# EUROPÄISCHE PATENTSCHRIFT

(11) **EP 3 552 035 B1**
(45) Veröffentlichungstag und Bekanntmachung des Hinweises auf die Patenterteilung: **19.04.2023**
(21) Anmeldenummer: 17822562.9
(22) Anmeldetag: 04.12.2017
(51) Int. Cl.: G01R 31/396, G01R 35/00, H01M 10/42, H01M 10/48, B60L 58/24, B60L 58/21, B60L 58/12, B60L 58/16, B60L 3/04, B60L 3/00

(54) **VERFAHREN ZUM BETREIBEN EINER TRAKTIONSBATTERIE FÜR EIN KRAFTFAHRZEUG UND BATTERIEMANAGEMENTVORRICHTUNG HIERFÜR**
METHOD FOR OPERATING A TRACTION BATTERY FOR A MOTOR VEHICLE AND BATTERY MANAGEMENT DEVICE THEREFOR
PROCÉDÉ POUR FAIRE FONCTIONNER UNE BATTERIE DE TRACTION CONÇUE POUR UN VÉHICULE AUTOMOBILE ET DISPOSITIF DE GESTION DE BATTERIE CORRESPONDANT

(30) Priorität: 08.12.2016 DE 102016224492
(43) Veröffentlichungstag der Anmeldung: 16.10.2019
(73) Patentinhaber: Volkswagen Aktiengesellschaft, 38440 Wolfsburg (DE)
(72) Erfinder: KROKER, Thorsten, 38108 Braunschweig (DE)
(86) Internationale Anmeldenummer: PCT/EP2017/081281
(87) Internationale Veröffentlichungsnummer: WO 2018/104189

(56) Entgegenhaltungen:
- EP-A1- 2 579 048
- WO-A1-2016/143678
- DE-A1-102014 202 622
- DE-A1-102014 214 996
- US-A1- 2015 008 931

## Beschreibung

### Technischer Hintergrund

Die Erfindung betrifft Traktionsbatterien für Kraftfahrzeuge, insbesondere das Vorsehen von Fehlerbetriebsarten für Traktionsbatterien.

### Technischer Hintergrund

Traktionsbatterien für Elektrofahrzeuge weisen in der Regel eine Reihe von Batteriezellen auf, die in einer Kombination von Reihen und Parallelschaltungen verschaltet sind, um einen zum Antrieb eines Elektroantriebs eines Kraftfahrzeugs benötigten Strom bei einer vorgegebenen Batteriespannung zu liefern.

Um den Zustand der Traktionsbatterie festzustellen, werden Zellenspannungen der Batteriezellen und der Batteriestrom überwacht. Dazu sind eine oder mehrere Zellenüberwachungseinheiten vorgesehen, die jeweils einer Anzahl von Batteriezellen zugeordnet sind und eine Spannungsmessung und Überprüfung sowie ggfs. eine Strommessung vornehmen. Weiterhin wird auf die Funktionsfähigkeit der Zellenüberwachungseinheiten auf fehlerhafte Funktion überwacht.

Die Spannungsüberwachung der Batteriezellen ist in der Regel mit einem ASIL-Level von C belegt, so dass die Spannungsmessung über zwei getrennte Mess- und Überwachungspfade realisiert werden sollte. Fällt eine Spannungsmessung bzw. fallen beide Spannungsmessungen aus, ist vorgesehen, die gesamte Fahrzeugbatterie abzuschalten, da nicht erkannte Fehlfunktionen oder defekte Batteriezellen ein Sicherheitsrisiko darstellen können.

Das Abschalten der gesamten Traktionsbatterie kann bei rein batteriebetriebenen Kraftfahrzeugen zu einem Liegenbleiben führen. Dies stellt jedoch aus technischer Hinsicht eine drastische Maßnahme dar, da in den überwiegenden Fällen die Wahrscheinlichkeit eines kritischen Defekt in einer Batteriezelle bei Ausfall einer Spannungsüberwachung sehr gering ist.

Die Druckschrift US2015/008931 A1 offenbart ein Verfahren zum Betreiben eines Batteriesystems mit einer Traktionsbatterie und einer oder mehreren Zellenüberwachungseinheiten, die jeweils Zellenspannungen einer Anzahl von Batteriezellen einer Zellenanordnung überwachen, wobei bei Feststellen eines Fehlers in einer der Zellenüberwachungseinheiten redundante Komponenten benutzt werden und die Traktionsbatterie weiter betrieben wird

Die Druckschrift WO2016/143678 A1 offenbart ein Verfahren zum Betreiben eines Batteriesystems mit einer Traktionsbatterie und einer oder mehreren Zellenüberwachungseinheiten, die jeweils Zellenspannungen einer Anzahl von Batteriezellen einer Zellenanordnung überwachen, wobei bei Feststellen eines Fehlers in einer der Zellenüberwachungseinheiten die Fahrzeugsteuerung angewiesen wird, das Fahrzeug mit limitierter Leistung weiter zu betreiben.

Die Druckschrift EP2579048 A1 offenbart ein Verfahren zum Betreiben eines Batteriesystems mit einer Traktionsbatterie, einer Batterie-Managementvorrichtung und einer oder mehreren Zellenüberwachungseinheiten, die jeweils Zellenspannungen einer Anzahl von Batteriezellen einer Zellenanordnung überwachen, wobei bei Feststellen eines Fehlers in einer der Zellenüberwachungseinheiten Korrekturwerte der Zellenüberwachungseinheiten erzeugt werden.

Die Druckschrift DE 10 2014 214996 A1 offenbart ein Verfahren zum Betrieb eines Batteriesystems mit mehreren Batteriezellen und einem Batteriemanagementsystem zur Überwachung und Steuerung der Batteriezellen, wobei eine erste Messkette und eine zweite Messkette zur redundanten Erfassung von Messdaten an den Batteriezellen und jeweils zur Durchführung von Diagnosen an den Batteriezellen und eines Ladungszustandsausgleichs der Batteriezellen eingerichtet sind, wobei im Falle des Ausfalls einer der Messketten das Batteriesystem die andere Messkette benutzt.

Die Druckschrift DE 10 2014 202622 A1 offenbart ein Verfahren zum Überwachen einer Batterie mit mehreren Batteriezellen, wobei einzelnen Batteriezellen und/oder einzelnen Batteriemodulen wenigstens eine Sensoreinheit zugeordnet ist, wobei bei Erkennen eines Fehlers basierend auf einem zeitlichen Verlauf von Zustandsparametern einzelner Batteriezellen oder einzelner Batteriemodule die Betriebsparameter der Batterie angepasst werden oder die Batterie abgeschaltet wird.

Es ist Aufgabe der vorliegenden Erfindung, den Betrieb einer Traktionsbatterie zuverlässiger zu machen und die Wahrscheinlichkeit eines Abschaltens der Traktionsbatterie aufgrund eines Ausfalls der Zellenüberwachung zu reduzieren.

### Offenbarung der Erfindung

Diese Aufgabe wird durch das Verfahren zum Betreiben einer Traktionsbatterie für ein Kraftfahrzeug mit Elektroantrieb gemäß Anspruch 1 sowie durch die Batteriemanagementvorrichtung und das Batteriesystem gemäß den nebengeordneten Ansprüchen gelöst.

Weitere Ausgestaltungen sind in den abhängigen Ansprüchen angegeben.

Gemäß einem ersten Aspekt ist ein Verfahren zum Betreiben eines Batteriesystems, insbesondere für ein Kraftfahrzeug mit Elektroantrieb, mit einer Traktionsbatterie, einer Batterie-Managementvorrichtung und mit einer oder mehreren Zellenüberwachungseinheiten vorgesehen, die jeweils Zellenspannungen einer Anzahl von Batteriezellen einer Zellenanordnung überwachen, mit folgenden Schritten:
- Überwachen der einen oder der mehreren Zellenüberwachungseinheiten;Bei Feststellen eines Fehlers in einer der Zellenüberwachungseinheiten, Einnehmen einer Fehlerbetriebsart der Traktionsbatterie abhängig von Zustandsdaten der der betreffenden Zellenüberwachungseinheit zugeordneten Zellenanordnung, wobei die Fehlerbetriebsart ein Einstellen einer Lade- und/oder Rekuperationssperre für die Traktionsbatterie umfasst.

Das obige Verfahren betrifft ein Batteriesystem mit einer Batterie-Managementvorrichtung und einer oder mehreren Zellenüberwachungseinheiten, die jeweils Zellenspannungen einer Anzahl von Batteriezellen überwachen. Die Zellenüberwachungseinheiten überwachen Zellenspannungen der zugeordneten Batteriezellen und überprüfen auch, ob diese innerhalb eines vorgegebenen Spannungsbereichs liegen. Es wird ein Fehler in einer Zellenüberwachungseinheit festgestellt, indem ein Fehlersignal detektiert wird. Das Fehlersignal kann generiert werden, wenn die Spannungsüberwachung durch einen Defekt in der betreffenden Zellenüberwachungseinheit ausfällt. Es kann auch ein Fehler festgestellt werden, wenn die Zellenüberwachungseinheit ausfällt, was von der Batterie-Managementvorrichtung durch z.B. ein Fehlen eines Signals oder durch Erkennen unplausibler Signale von der Zellenüberwachungseinheit festgestellt werden kann.

Eine Idee des obigen Verfahrens besteht darin, bei Auftreten eines Fehlers in mindestens einer der Zellenüberwachungseinheiten basierend auf historischen (d.h. dem zeitlichen Verlauf der) und aktuellen Zustandsdaten der der betreffenden Zellüberwachungseinheit zugeordneten Batteriezellen zu entscheiden, in welcher Betriebsart die Traktionsbatterie weiterbetrieben wird oder ob diese abgeschaltet wird.

Anhand der historischen Zustandsdaten für die betreffenden Batteriezellen kann also eine Wahrscheinlichkeit abgeschätzt werden, mit der nach dem Auftreten eines Fehlers in einer Zellenüberwachungseinheit auch ein kritischer Fehler in den zugeordneten Batteriezellen auftreten kann. Kritische Fehler in Batteriezellen, die häufig durch eine erhebliche Erhöhung des Innenwiderstands gekennzeichnet sind, können zu einer Schädigung und/oder Zerstörung der Traktionsbatterie und darüber hinaus zu einer erhöhten Brand- oder Explosionsgefahr führen und müssen daher mit sehr hoher Zuverlässigkeit vermieden werden.

Das obige Verfahren hat dabei den Vorteil, dass durch das Evaluieren des Gefahrenrisikos beim Weiterbetrieb der Batteriezellen nach dem Auftreten eines Fehlers in einer Zellenüberwachungseinheit eine flexible Entscheidung über den Weiterbetrieb der der Zellenüberwachungseinheit zugeordneten Batteriezellen getroffen werden kann. In vielen Fällen kann dann anstelle der üblichen vollständigen Abschaltung bzw. Deaktivierung des Batteriesystems ein Weiterbetrieb, insbesondere in einer Fehlerbetriebsart, ohne zu einer nennenswerten Erhöhung des Gebrauchsrisikos zu führen.

Insbesondere kann die Fehlerbetriebsart der Traktionsbatterie eingenommen werden, wenn die Zustandsdaten eine geringere Wahrscheinlichkeit eines Auftretens eines kritischen Fehlers in einer der Batteriezellen des der Zellenüberwachungseinheit zugeordneten Zellenmoduls angeben als durch einen Wahrscheinlichkeitsschwellenwert vorgegeben ist.

Es kann vorgesehen sein, dass die Zustandsdaten des Batteriesystems zuletzt erfasste Batterieparameter und/oder historische Batterieparameter und Verläufe von Batterieparametern umfassen und insbesondere eine oder mehrere der folgenden umfassen:
- einen Gesundheitszustand (SOH: State of Health) der einzelnen Batteriezellen (das definierte Lebensdauerende einer Batteriezelle liegt bei einem SOH zwischen 70 und 80%),
- eine gesamte Betriebsdauer der Traktionsbatterie,
- einen maximalen Ladestrom oder ein Ladestromintegral des letzten Ladevorgangs,
- einen maximalen Entladestrom oder ein Entladestromintegral des letzten Entladevorgangs;
- einen durchschnittlichen Ladestrom über eine Anzahl von Ladevorgängen;
- einen durchschnittlichen Entladestrom über eine Anzahl von Entladevorgängen;
- einen aktuellen Entladestrom;
- Zeitpunkte von Verletzungen von Strom- und Spannungsgrenzen für die einzelnen Batteriezellen;
- Ladezustände der einzelnen Batteriezellen, und
- eine Temperatur der einzelnen der Zellenanordnungen ermittelt.

Gemäß einer Ausführungsform kann bei Detektieren des Fehlers in der Zellenüberwachungseinheit, die Traktionsbatterie abhängig von Zustandsdaten des der betreffenden Zellenüberwachungseinheit zugeordneten Zellenmoduls abgeschaltet werden.

Es kann vorgesehen sein, dass die Fehlerbetriebsart folgende Maßnahme umfasst:
- Einschränkung der Leistungsabgabe und -aufnahme auf eine verminderte Leistungsmaximalgrenze.

Gemäß einem weiteren Aspekt ist eine Batteriemanagementvorrichtung zum Betreiben einer Traktionsbatterie, insbesondere für ein Kraftfahrzeug mit Elektroantrieb, vorgesehen, wobei die Batteriemanagementvorrichtung ausgebildet ist, um:
- eine oder mehrere Zellenüberwachungseinheiten zu überwachen, die jeweils Zellenspannungen einer Anzahl von Batteriezellen einer Zellenanordnung der Traktionsbatterie überwachen;
- bei Detektieren eines Fehlers in einer der Zellenüberwachungseinheiten, eine Fehlerbetriebsart der Traktionsbatterie einzunehmen abhängig von Zustandsdaten der der betreffenden Zellenüberwachungseinheit zugeordneten Zellenanordnung, wobei die Fehlerbetriebsart ein Einstellen einer Lade- und/oder Rekuperationssperre für die Traktionsbatterie umfasst..

Gemäß einem weiteren Aspekt ist ein Batteriesystem vorgesehen, umfassend:
- eine Traktionsbatterie mit einer Anzahl von Batteriezellen jeweils in einer von einer oder mehreren Zellenanordnungen,
- die obige Batterie-Managementvorrichtung;
- eine oder mehrere Zellenüberwachungseinheiten, die jeweils Zellenspannungen einer Anzahl von Batteriezellen einer Zellenanordnung überwachen.

### Kurzbeschreibung der Zeichnungen

Ausführungsformen werden nachfolgend anhand der beigefügten Zeichnungen näher erläutert. Es zeigen:
- Figur 1: eine schematische Darstellung eines Batteriesystems mit einer Batterie-Managementvorrichtung, Zellüberwachungseinheiten und zugeordneten Batteriezellen; und
- Figur 2: ein Flussdiagramm zur Veranschaulichung eines Verfahrens zum Betreiben des Batteriesystems der Figur 1.

### Beschreibung von Ausführungsformen

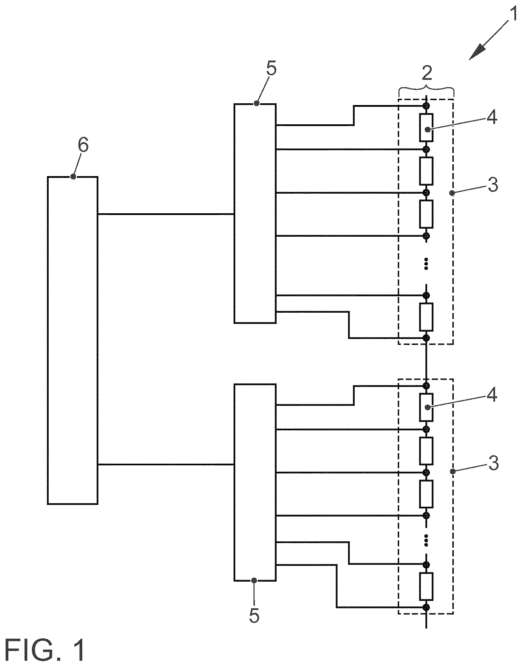

Figur 1 zeigt eine schematische Darstellung eines Batteriesystems 1 mit einer Traktionsbatterie 2, die aus Zellmodulen 3 zusammengesetzt ist. Die Traktionsbatterie 2 kann beispielsweise zum Bereitstellen von elektrischer Energie für einen Elektroantrieb eines Kraftfahrzeugs dienen.

Die Zellenmodule 3 weisen Batteriezellen 4 auf, die im vorliegenden Ausführungsbeispiel seriell verschaltet sind. Alternativ können die Zellenmodule 3 seriell und/oder parallel miteinander verschaltet sein, um gewünschte elektrische Parameter bzw. Eigenschaften der Traktionsbatterie 2 bereitzustellen.

Jedes der Zellenmodule 3 ist mit einer Zellenüberwachungseinheit 5 gekoppelt, die einen Spannungsabgriff für jede der Batteriezelle 4 aufweisen kann, um so die Zellenspannung jeder der Batteriezellen 4 erfassen zu können. Auch kabellose Verfahren zur Messung der Spannung können angewendet werden. Weiterhin kann die Zellenüberwachungseinheit 5 überprüfen, ob eine der Batteriezellen 4 eine Über- oder Unterspannung aufweist, die aus einem von einem Normalbereich abweichenden Innenwiderstand der betreffenden Batteriezelle resultiert.

Die Zellenüberwachungseinheiten 5 sind jeweils mit einer Batterie-Managementvorrichtung 6 verbunden, so dass Informationen über Zellspannungen, Über- und Unterspannungen von einzelnen Batteriezellen 4 der Batterie-Managementvorrichtung 6 mitgeteilt werden können. Tritt ein Fehler in der Zellüberwachungseinheit 5 auf, der dazu führt, dass die Spannungsmessung der Batteriezelle 4 nicht durchgeführt werden kann und/oder keine Über-/Unterspannungsdetektion mehr durchgeführt werden kann, so wird ein entsprechendes Fehlersignal an die Batterie-Managementvorrichtung 6 weitergeleitet. Weiterhin kann die Batterie-Managementvorrichtung 6 auch Funktionen, wie eine Lastverteilung (Load-Balancing) oder dergleichen wahrnehmen.

Die Batterie-Managementvorrichtung 6 wertet die Informationen der angeschlossenen Zellenüberwachungseinheiten 5 aus und speichert ggfs. historische Werte der Zellenspannungen.

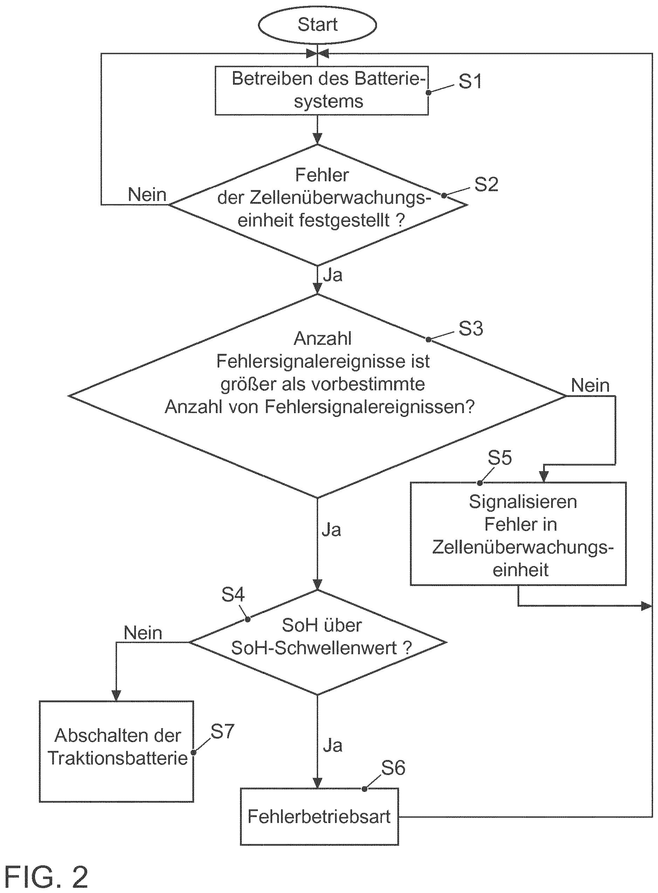

Weiterhin führt die Batterie-Managementvorrichtung 6 eine Fehlerbehandlung durch, die anhand des Flussdiagramms der Figur 2 näher erläutert wird.

In Schritt S1 wird das Batteriesystem 1 durch die Batterie-Managementvorrichtung 6 in herkömmlicher Weise betrieben. Dabei werden Zustandsdaten des Batteriesystems 1 regelmäßig erfasst, und darüber hinaus eine Historie von einer oder mehreren der Zustandsdaten aufgezeichnet. Die Zustandsdaten können umfassen:
- einen Gesundheitszustand (SOH: State of Health) der einzelnen Batteriezellen 4,
- einen Ladezustand und/oder einen Verlauf des Ladezustands
- der gesamten Betriebsdauer der Traktionsbatterie 2,
- einen maximalen Ladestrom und/oder ein Ladestromintegral des letzten Ladevorgangs,
- einen maximalen Entladestrom und/oder ein Entladestromintegral des letzten Entladevorgangs;
- des Ladestroms des letzten Ladevorgangs,
- einen durchschnittlichen Ladestrom über eine Anzahl von Ladevorgängen;
- einen durchschnittlichen Entladestrom über eine Anzahl von Entladevorgängen;
- der Entladestrom des letzten Entladevorgangs;
- Zeitpunkte von Verletzungen von Strom- und Spannungsgrenzen für die einzelnen Batteriezellen
- den Ladezustand der einzelnen Batteriezellen und
- die Temperatur der einzelnen Batteriezellen 4 bzw. der Zellenanordnungen 3, deren Verlauf und/oder einer Temperaturintegrationsgröße,
- eine Gesamtbetriebsdauer, und
- eine Leerlaufzeitdauer.

Die Batterie-Managementvorrichtung 6 kann darüber hinaus die Traktionsbatterie 2 abschalten bzw. deaktivieren oder Fehlerbetriebsarten einstellen. Die Fehlerbetriebsart sieht vor, die maximal abrufbare Entladeleistung zu beschränken und/oder die maximal zuführbare Ladeleistung zu beschränken. Dies kann beispielsweise durch eine entsprechende Maximalleistungsvorgabe an die Fahrzeugsteuerung erfolgen.

In Schritt S2 wird überprüft, ob ein Fehler in einer der Zellenüberwachungseinheiten 5 feststellbar ist. Ein Fehler kann z.B. als ein Fehlersignal, d.h. ein Signal, das einen Fehler anzeigt, bereitgestellt werden. Ein solches Fehlersignal kann z.B. in der entsprechenden Zellenüberwachungseinheit 5 generiert werden, wenn eine dort implementierte Funktion einen Fehler feststellt. Auch kann ein Signalabriss von kontinuierlich oder regelmäßig an die Batterie- Managementvorrichtung 6 übermittelte Datensignale oder Auswertesignale (z.B. Auswertesignale, die ein Überschreiten oder Unterschreiten einer vorgegebenen Zellenspannungsschwelle angeben) als ein solches Fehlersignal betrachtet werden. Ferner kann in der Batterie- Managementvorrichtung 6 ein sogenannter Watchdog vorgesehen sein, der ein Ausbleiben periodischer Signale, die bei korrekter Funktion der Zellenüberwachungseinheit 5 bereitgestellt werden, als Fehlersignal werten.

Wird festgestellt, dass ein Fehler in einer der Zellenüberwachungseinheiten 5 vorliegt (Alternative: Ja), wird das Verfahren mit Schritt S3 fortgesetzt, andernfalls (Alternative: Nein) wird zu Schritt S1 zurückgesprungen.

Nachdem ein Fehler festgestellt worden ist, wird in Schritt S3 überprüft, ob das Fehlersignal mehr als eine vorbestimmte Anzahl von Malen aufgetreten ist. Die vorbestimmte Anzahl von Malen kann "1" betragen oder größer als "1" vorgegeben sein.

Ist dies der Fall (Alternative: Ja) wird das Verfahren mit Schritt S4 fortgesetzt, andernfalls (Alternative: Nein) wird das Verfahren über Schritt S5 mit Schritt S1 fortgesetzt.

In Schritt S5 wird ein Fehler in der Zellenüberwachungseinheit signalisiert, beispielsweise durch die Anzeige eines optischen Warnsignals.

In Schritt S4 wird der zuletzt ermittelte Gesundheitszustand (SoH) der Batteriezellen 4 der Zellenanordnung 3 überprüft. Liegt dieser über einem vorgegebenen SoH-Schwellenwert, wie z.B. von 90% (Alternative: Ja), so wird das Verfahren mit Schritt S6 fortgesetzt, andernfalls wird das Verfahren mit Schritt S7 fortgesetzt.

In Schritt S7 wird die Traktionsbatterie abgeschaltet, da das Risiko eines kritischen Zustands in einer der Batteriezellen bei fehlender Überwachung und geringen Gesundheitszustand (SoH) erhöht ist.

Alternativ oder zusätzlich zu der Abfrage in Schritt S4 können Bedingungen definiert werden, die eine Schwelle einer Wahrscheinlichkeit für das Auftreten eines kritischen Fehlers in den Batteriezellen 4 der Zellenanordnung 3, die der fehlerhaften Zellenüberwachungseinheit 5 zugeordnet sind, angeben. Diese Bedingungen können weitere oder o.a. Zustandsdaten oder eine Kombination dieser Zustandsdaten betreffen.

In Schritt S6 kann eine Fehlerbetriebsart eingenommen werden, die kein vollständiges Abschalten der Traktionsbatterie beinhaltet. Ein Abschalten der Traktionsbatterie ist nicht zweckmäßig, da die Batteriezelle bzw. die Zellanordnung eine ausreichend hohe Qualität hat und mit einem Ausfall einzelner Batteriezellen nicht zu rechnen ist. So kann auch ein Temperaturschwellenwert definiert werden, wobei bei einer Temperatur der Traktionsbatterie über dem Temperaturschwellenwert das Verfahren mit Schritt S7 die Traktionsbatterie abschaltet und andernfalls die Fehlerbetriebsart einnimmt. Alternativ oder zusätzlich kann ein Strom- und/oder Spannungsschwellenwert für die nicht fehlerhaften Zellenüberwachungseinheiten definiert werden, um den Gesamtzustand der Traktionsbatterie abzuleiten.

Beispielsweise kann die Fehlerbetriebsart abhängig von dem zuletzt bestimmten Ladezustand, von dem zuletzt bestimmten Gesundheitszustand, von der Temperatur der Batteriezelle bzw. der betreffenden Zellenanordnung 2, der Fahrzeit seit dem letzten Starten des Kraftfahrzeugs eingenommen werden.

Die Fehlerbetriebsart kann eine oder mehrere der folgenden Maßnahmen umfassen:
- Einschränkung der Leistungsabgabe auf eine verminderte Leistungsmaximalgrenze, d.h. die Leistungsmaximalgrenze ist gegenüber der Leistungsmaximalgrenze im Normalbetrieb reduziert. Durch die Reduzierung der Leistung wird der Stromfluss durch die Batteriezellen reduziert, so dass selbst bei fehlerhafter Batteriezelle mit einem erhöhten Innenwiderstand die für Batteriezellen kritischen oberen und unteren Spannungsgrenzen nicht über- bzw. unterschritten werden; zumindest aber
- Einstellen einer Ladesperre für die Traktionsbatterie, so dass ein Aufladen der Batteriezellen 4 verhindert wird, bis der Fehler der Zellenüberwachungseinheit 5 behoben worden ist.

## Patentansprüche

1. Verfahren zum Betreiben eines Batteriesystems (1), insbesondere für ein Kraftfahrzeug mit Elektroantrieb, mit einer Traktionsbatterie (2), einer Batterie-Managementvorrichtung (6) und einer oder mehreren Zellenüberwachungseinheiten (5), die jeweils Zellenspannungen einer Anzahl von Batteriezellen (4) einer Zellenanordnung (3) überwachen, mit folgenden Schritten:
- Überwachen der einen oder der mehreren Zellenüberwachungseinheiten (5);
- bei Feststellen eines Fehlers in einer der Zellenüberwachungseinheiten (5), Einnehmen einer Fehlerbetriebsart der Traktionsbatterie (2) abhängig von Zustandsdaten der der betreffenden Zellenüberwachungseinheit (5) zugeordneten Zellenanordnung (3),
**dadurch gekennzeichnet dass**,
die Fehlerbetriebsart ein Einstellen einer Lade- und/oder Rekuperationssperre für die Traktionsbatterie (2) umfasst.

2. Verfahren nach Anspruch 1, wobei die Fehlerbetriebsart der Traktionsbatterie (2) eingenommen wird, wenn die Zustandsdaten eine geringere Wahrscheinlichkeit eines Auftretens eines kritischen Fehlers in einer der Batteriezellen (4) des der Zellenüberwachungseinheit (5) zugeordneten Zellenmoduls angeben als durch einen Wahrscheinlichkeitsschwellenwert vorgegeben ist.

3. Verfahren nach Anspruch 1 oder 2, wobei die Zustandsdaten des Batteriesystems 1 zuletzt erfasste Batterieparameter und/oder historische Batterieparameter und Verläufe von Batterieparametern umfassen und insbesondere eine oder mehrere der folgenden umfassen:
- einen Gesundheitszustand (SOH: State of Health) der einzelnen Batteriezellen (4),
- einen Ladezustand und/oder einen Verlauf des Ladezustands;
- der gesamten Betriebsdauer der Traktionsbatterie (2);
- einen maximalen Ladestrom und/oder ein Ladestromintegral des letzten Ladevorgangs;
- einen maximalen Entladestrom und/oder ein Entladestromintegral des letzten Entladevorgangs;
- des Ladestroms des letzten Ladevorgangs;
- einen durchschnittlichen Ladestrom über eine Anzahl von Ladevorgängen;
- einen durchschnittlichen Entladestrom über eine Anzahl von Entladevorgängen;
- der Entladestrom des letzten Entladevorgangs;
- Zeitpunkte von Verletzungen von Strom- und Spannungsgrenzen für die einzelnen Batteriezellen;
- den Ladezustand der einzelnen Batteriezellen (4);
- die Temperatur der einzelnen Batteriezellen bzw. der Zellenanordnungen, deren Verlauf und/oder einer Temperaturintegratorgröße;
- eine Gesamtbetriebsdauer;
- eine Leerlaufzeitdauer; und
- Entlade- oder Ladeströme von nicht fehlerhaften Zellenüberwachungseinheiten.

4. Batterie-Managementvorrichtung (6) zum Betreiben einer Traktionsbatterie (2), insbesondere für ein Kraftfahrzeug mit Elektroantrieb, wobei die Batterie-Managementvorrichtung (6) ausgebildet ist, um:
- eine oder mehrere Zellenüberwachungseinheiten (5) zu überwachen, die jeweils Zellenspannungen einer Anzahl von Batteriezellen einer Zellenanordnung (3) der Traktionsbatterie (2) überwachen;
- um bei Detektieren eines Fehlers in einer der Zellenüberwachungseinheiten (5) abhängig von Zustandsdaten der der betreffenden Zellenüberwachungseinheit (5) zugeordneten Zellenanordnung (3), eine Fehlerbetriebsart der Traktionsbatterie (2) einzunehmen,
**dadurch gekennzeichnet dass**,
die Fehlerbetriebsart ein Einstellen einer Lade- und/oder Rekuperationssperre für die Traktionsbatterie (2) umfasst.

5. Batteriesystem umfassend:
- eine Traktionsbatterie (2) mit einer Anzahl von Batteriezellen (4) jeweils in einer von einer oder mehreren Zellenanordnungen,
- eine Batterie-Managementvorrichtung (6) nach Anspruch 4;
- eine oder mehrere Zellenüberwachungseinheiten (5), die jeweils Zellenspannungen einer Anzahl von Batteriezellen (4) einer Zellenanordnung (3) überwachen.

## Claims

1. Method for operating a battery system (1), in particular for a motor vehicle having an electric drive, the battery system having a traction battery (2), a battery management device (6), and one or more cell monitoring units (5) which each monitor cell voltages of a number of battery cells (4) of a cell arrangement (3), the method having the following steps:
- monitoring the one or more cell monitoring units (5);
- if a fault is detected in one of the cell monitoring units (5), assuming a fault operating mode of the traction battery (2) depending on state data of the cell arrangement (3) associated with the relevant cell monitoring unit (5),
**characterized in that**
the fault operating mode comprises setting a charging and/or energy recovery barrier for the traction battery (2).

2. Method according to claim 1, wherein the fault operating mode of the traction battery (2) is assumed when the state data indicates a lower probability of a critical fault occurrence in one of the battery cells (4) of the cell module associated with the cell monitoring unit (5) than is predetermined by a probability threshold value.

3. Method according to either claim 1 or claim 2, wherein the state data of the battery system 1 comprises last detected battery parameters and/or historical battery parameters and profiles of battery parameters and in particular comprise one or more of the following:
- a state of health (SOH) of the individual battery cells (4),
- a state of charge and/or a profile of the state of charge;
- the total operating duration of the traction battery (2);
- a maximum charge current and/or a charge current integral of the last charge process;
- a maximum discharge current and/or a discharge current integral of the last discharge process;
- the charge current of the last charge process;
- an average charge current over a number of charge processes;
- an average discharge current over a number of discharge processes;
- the discharge current of the last discharge process;
- times of violations to current and voltage limits for the individual battery cells;
- the state of charge of the individual battery cells (4);
- the temperature of the individual battery cells or of the cell arrangements, their profile and/or a temperature integrator variable;
- a total operating duration;
- an idle time duration; and
- discharge or charge currents of non-faulty cell monitoring units.

4. Battery management device (6) for operating a traction battery (2), in particular for a motor vehicle having an electric drive, the battery management device (6) being designed to:
- monitor one or more cell monitoring units (5) which each monitor cell voltages of a number of battery cells of a cell arrangement (3) of the traction battery (2);
- assume a fault operating mode of the traction battery (2) when a fault is detected in one of the cell monitoring units (5) depending on state data of the cell arrangement (3) associated with the relevant cell monitoring unit (5),
**characterized in that**
the fault operating mode comprises setting a charging and/or energy recovery barrier for the traction battery (2).

5. Battery system, comprising:
- a traction battery (2) having a number of battery cells (4) in one of one or more cell arrangements,
- a battery management device (6) according to claim 4;
- one or more cell monitoring units (5) which each monitor cell voltages of a number of battery cells (4) of a cell arrangement (3).

## Revendications

1. Procédé permettant de faire fonctionner un système de batterie (1), en particulier pour un véhicule automobile à entraînement électrique, comportant une batterie de traction (2), un dispositif de gestion de batterie (6) et une ou plusieurs unités de surveillance de cellules (5) qui surveillent respectivement des tensions de cellules d'un certain nombre de cellules de batterie (4) d'un agencement de cellules (3), comportant les étapes suivantes :
- surveillance de la ou des unités de surveillance de cellules (5) ;
- en cas de détection d'une défaillance dans l'une des unités de surveillance de cellules (5), adoption d'un mode de fonctionnement de défaillance de la batterie de traction (2) en fonction de données d'état de l'agencement de cellules (3) associé à l'unité de surveillance de cellules (5) concernée,
**caractérisé en ce que**
le mode de fonctionnement de défaillance comprend un réglage d'un blocage de charge et/ou de récupération pour la batterie de traction (2).

2. Procédé selon la revendication 1, dans lequel le mode de fonctionnement de défaillance de la batterie de traction (2) est adopté lorsque les données d'état indiquent une probabilité d'apparition d'une défaillance critique dans l'une des cellules de batterie (4) du module de cellules associé à l'unité de surveillance de cellules (5) plus faible que celle prédéterminée par une valeur seuil de probabilité.

3. Procédé selon la revendication 1 ou 2, dans lequel les données d'état du système de batterie 1 comprennent des paramètres de batterie détectés en dernier et/ou des paramètres de batterie précédents et des courbes de paramètres de batterie et comprennent en particulier un ou plusieurs des éléments suivants :
- un état de santé (SOH : état de santé) des cellules de batterie (4) individuelles,
- un état de charge et/ou une courbe de l'état de charge ;
- la durée de fonctionnement totale de la batterie de traction (2) ;
- un courant de charge maximal et/ou un courant de charge intégral du dernier processus de charge ;
- un courant de décharge maximal et/ou un courant de décharge intégral du dernier processus de décharge ;
- le courant de charge du dernier processus de charge ;
- un courant de charge moyen sur un certain nombre de processus de charge ;
- un courant de décharge moyen sur un certain nombre de processus de décharge ;
- le courant de décharge du dernier processus de décharge ;
- des moments de violation de limites de courant et de tension pour les cellules de batterie individuelles ;
- l'état de charge des cellules de batterie (4) individuelles ;
- la température des cellules de batterie individuelles ou des agencements de cellules, leur courbe et/ou une taille d'intégrateur de température ;
- une durée de fonctionnement totale ;
- une période d'inactivité ; et
- des courants de décharge ou de charge d'unités de surveillance de cellules non défaillantes.

4. Dispositif de gestion de batterie (6) permettant de faire fonctionner une batterie de traction (2), en particulier pour un véhicule automobile à entraînement électrique, dans lequel le dispositif de gestion de batterie (6) est configuré pour :
- surveiller une ou plusieurs unités de surveillance de cellules (5) qui surveillent respectivement des tensions de cellules d'un certain nombre de cellules de batterie d'un agencement de cellules (3) de la batterie de traction (2) ;
- en cas de détection d'une défaillance dans l'une des unités de surveillance de cellules (5), en fonction de données d'état de l'agencement de cellules (3) associé à l'unité de surveillance de cellules (5) concernée, adopter un mode de fonctionnement de défaillance de la batterie de traction (2),
**caractérisé en ce que**
le mode de fonctionnement de défaillance comprend un réglage d'un blocage de charge et/ou de récupération pour la batterie de traction (2).

5. Système de batterie comprenant :
- une batterie de traction (2) comportant un certain nombre de cellules de batterie (4) dans respectivement un agencement de cellules parmi un ou plusieurs agencements de cellules,
- un dispositif de gestion de batterie (6) selon la revendication 4 ;
- une ou plusieurs unités de surveillance de cellules (5) qui surveillent respectivement des tensions de cellules d'un certain nombre de cellules de batterie (4) d'un agencement de cellules (3).
